# FASCICULE DE BREVET EUROPEEN

(11) **EP 4 380 343 B1**
(45) Date de publication et mention de la délivrance du brevet: **08.07.2026**
(21) Numéro de dépôt: 23211034.6
(22) Date de dépôt: 21.11.2023
(51) Int. Cl.: H10N 70/20, H10N 70/00

(54) **COMMUTATEUR A BASE DE MATERIAU A CHANGEMENT DE PHASE**
SCHALTER AUF BASIS VON PHASENWECHSELMATERIAL
PHASE CHANGE MATERIAL BASED SWITCH

(30) Priorité: 02.12.2022 FR 2212681
(43) Date de publication de la demande: 05.06.2024
(73) Titulaire: Commissariat à l'Energie Atomique et aux Energies Alternatives, 75015 Paris (FR)
(72) Inventeur: PUYAL, Vincent, 38054 GRENOBLE CEDEX 09 (FR); REIG, Bruno, 38054 GRENOBLE CEDEX 09 (FR); CATHELIN, Philippe, 38190 LAVAL EN BELLEDONNE (FR); MONFRAY, Stéphane, 38320 EYBENS (FR); FLEURY, Alain, 73000 BARBERAZ (FR); GIANESELLO, Frédéric, 73190 SAINT JEOIRE PRIEURE (FR)
(74) Mandataire: Cabinet Beaumont

(56) Documents cités:
- EP-A1- 3 457 491
- US-A1- 2016 079 019
- US-B1- 9 368 720

## Description

### Domaine technique

La présente description concerne de façon générale les dispositifs électroniques. La présente description concerne plus particulièrement les commutateurs à base d'un matériau à changement de phase capable d'alterner entre une phase cristalline, électriquement conductrice, et une phase amorphe, électriquement isolante.

### Technique antérieure

Diverses applications tirent profit de commutateurs, ou interrupteurs, à base d'un matériau à changement de phase pour permettre ou empêcher une circulation d'un courant électrique dans un circuit. De tels commutateurs peuvent notamment être mis en œuvre dans des applications de communication radiofréquence, par exemple pour commuter une antenne entre des modes d'émission et de réception, activer un filtre correspondant à une bande de fréquences, etc.

Le document EP 3457491A1 décrit un système de découplage RF/DC pour commutateurs RF à base de matériau à changement de phase.

Le document US 2016/0079019A1 décrit des systèmes de commutateur distribués à matériau à changement de phase.

Le document US 9368720B1 décrit un procédé de fabrication de commutateurs RF à matériau à changement de phase avec des diélectriques thermiques.

### Résumé de l'invention

Il existe un besoin d'améliorer les commutateurs à base d'un matériau à changement de phase existants.

Un mode de réalisation pallie tout ou partie des inconvénients des commutateurs à base d'un matériau à changement de phase connus.

Un aspect d'un mode de réalisation vise plus particulièrement un commutateur présentant une vitesse de commutation accrue.

Un autre aspect d'un mode de réalisation vise plus particulièrement un commutateur présentant une tenue en tension, ou en puissance, améliorée.

L'invention est définie par la revendication 1. Les revendications dépendantes couvrent des modes de réalisation et variantes de l'invention.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1A et la figure 1B sont des vues, respectivement de dessus et en coupe selon le plan AA de la figure 1A, schématiques et partielles, d'un exemple d'un commutateur à base d'un matériau à changement de phase selon un mode de réalisation ;
la figure 2 est une vue de dessus, schématique et partielle, d'un exemple d'un commutateur à base d'un matériau à changement de phase selon un mode de réalisation ; et
la figure 3A et la figure 3B sont des vues, respectivement de dessus et en coupe selon le plan AA de la figure 3A, schématiques et partielles, d'un exemple d'un commutateur à base d'un matériau à changement de phase selon un mode de réalisation.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les circuits de commande des commutateurs à base d'un matériau à changement de phase et les applications dans lesquelles peuvent être prévus de tels commutateurs n'ont pas été détaillés, les modes de réalisation et variantes décrits étant compatibles avec les circuits de commande des commutateurs à base d'un matériau à changement de phase usuels et avec les applications usuelles mettant en œuvre des commutateurs à base d'un matériau à changement de phase.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais « coupled ») entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes « avant », « arrière », « haut », « bas », « gauche », « droite », etc., ou relative, tels que les termes « dessus », « dessous », « supérieur », « inférieur », etc., ou à des qualificatifs d'orientation, tels que les termes « horizontal », « vertical », etc., il est fait référence, sauf précision contraire, à l'orientation des figures.

Sauf précision contraire, les expressions « environ », « approximativement », « sensiblement », et « de l'ordre de » signifient à 10 % près, de préférence à 5 % près.

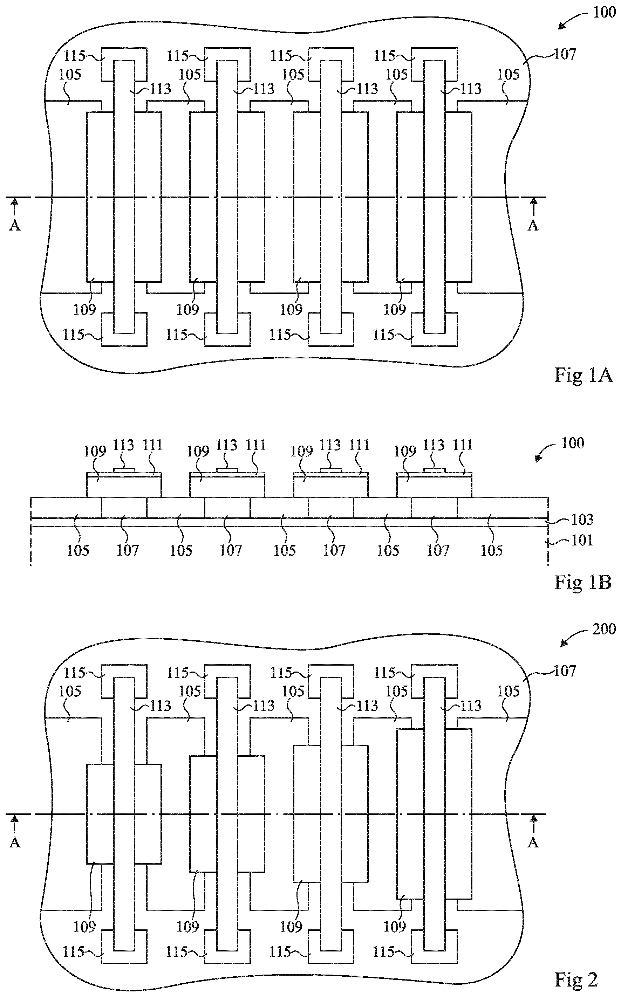

La figure 1A et la figure 1B sont des vues, respectivement de dessus et en coupe selon le plan AA de la figure 1A, schématiques et partielles, d'un exemple d'un commutateur 100 à base d'un matériau à changement de phase selon un mode de réalisation.

Dans l'exemple représenté, le commutateur 100 est formé dans et sur un substrat 101, par exemple une plaquette ou un morceau de plaquette en un matériau semiconducteur, par exemple le silicium.

De façon optionnelle, le substrat 101 est revêtu, sur l'une de ses faces (sa face supérieure, dans l'orientation de la figure 1B), d'une couche électriquement isolante 103. À titre d'exemple, la couche isolante 103 est en dioxyde de silicium et présente une épaisseur de l'ordre de 500 nm.

Dans l'invention le commutateur 100 comporte une ou plusieurs, par exemple cinq électrodes 105 coplanaires situées sur et en contact avec la face de la couche isolante 103 opposée au substrat 101. Les deux électrodes 105 les plus distantes l'une de l'autre (appelées électrodes radiofréquence), situées respectivement aux extrémités gauche et droite du commutateur 100, dans l'orientation des figures 1A et 1B, sont des électrodes de conduction destinées à être connectées à un circuit de communication radiofréquence (non détaillé). Dans cet exemple, les trois autres électrodes 105, interposées latéralement entre les deux électrodes 105 de conduction, sont par exemple des électrodes intermédiaires destinées à n'être reliées ou connectées à aucun autre élément conducteur et sont par exemple chacune à un potentiel flottant.

Les électrodes 105 sont par exemple en un matériau conducteur, par exemple un métal, par exemple le cuivre ou l'aluminium, ou en un alliage métallique. Chaque électrode 105 peut présenter une structure monocouche ou une structure multicouche comprenant par exemple, depuis la face supérieure de la couche isolante 103, une couche en titane présentant une épaisseur de l'ordre de 10 nm, une couche en un alliage de cuivre et d'aluminium présentant une épaisseur de l'ordre de 440 nm, une autre couche en titane présentant une épaisseur de l'ordre de 10 nm et une couche en nitrure de titane présentant une épaisseur de l'ordre de 100 nm. À titre d'exemple, chaque électrode 105 présente, en vue de dessus, une forme sensiblement rectangulaire.

Dans l'exemple illustré en figures 1A et 1B, une autre couche électriquement isolante 107 revêt des parties de la face supérieure de la couche isolante 103 non revêtues par les électrodes 105. Le matériau de la couche isolante 107 revêt les faces latérales des électrodes 105 et comble les espaces libres s'étendant latéralement entre les électrodes 105. La couche 107 isole électriquement les électrodes 105 entre elles. Dans l'exemple représenté, la couche isolante 107 affleure la face supérieure des électrodes 105. À titre d'exemple, la couche isolante 107 est en le même matériau que la couche isolante 103, par exemple en dioxyde de silicium.

Dans l'exemple représenté, le commutateur 100 comporte en outre quatre régions 109 en un matériau à changement de phase. Dans l'exemple illustré, les régions 109 en ledit matériau à changement de phase sont disjointes et relient chacune deux électrodes 105 adjacentes du commutateur 100. Plus précisément, dans l'exemple représenté, une première région 109 relie une première électrode 105 (par exemple l'électrode 105 de conduction de gauche, dans l'orientation des figures 1A et 1B) à une deuxième électrode 105 adjacente à la première électrode 105 (l'électrode 105 intermédiaire la plus proche de la première électrode 105, dans cet exemple), et une deuxième région 109, différente de la première région 109, relie la deuxième électrode 105 à une troisième électrode 105 adjacente à la deuxième électrode 105 (l'électrode 105 intermédiaire la plus proche de la deuxième électrode 105, dans cet exemple). En outre, dans cet exemple, une troisième région 109, différente des première et deuxième régions 109, relie la troisième électrode 105 à une quatrième électrode 105 adjacente à la troisième électrode 105 (l'électrode 105 intermédiaire la plus proche de la troisième électrode 105, dans cet exemple), et une quatrième région 109, différente des première, deuxième et troisième régions 109, relie la quatrième électrode 105 à une cinquième électrode 105 adjacente à la quatrième électrode 105 (l'électrode 105 de conduction de droite, dans cet exemple). Chaque région 109 en matériau à changement de phase revêt la face supérieure d'une partie de la couche 107 s'étendant latéralement entre les deux électrodes 105 adjacentes qu'elle relie, et se prolonge sur et en contact avec une partie de la face supérieure de chacune desdites électrodes 105. Chaque région 109 en matériau à changement de phase présente par exemple, en vue de dessus, une forme sensiblement rectangulaire.

Dans l'exemple illustré, les régions 109 en matériau à changement de phase du commutateur 100 présentent, en vue de dessus, des aires sensiblement identiques, aux dispersions de fabrication près. À titre d'exemple, chaque région 109 en matériau à changement de phase présente une longueur de l'ordre d'un ou plusieurs micromètres, par exemple égale à environ 1 µm, la longueur de chaque région 109 correspondant à une dimension latérale de ladite région 109 mesurée le long de la direction de conduction du commutateur 100. Dans l'exemple représenté, les régions 109 en matériau à changement de phase présentent en outre une même largeur, par exemple de l'ordre de plusieurs micromètres ou plusieurs dizaines de micromètres, la largeur de chaque région 109 correspondant à une dimension latérale de ladite région 109 mesurée le long d'une direction orthogonale à la direction de conduction du commutateur 100 (le long d'une direction orthogonale au plan de coupe de la figure 1B). Chaque région 109 en matériau à changement de phase présente par exemple une épaisseur comprise entre 100 et 300 nm.

À titre d'exemple, chaque région 109 du commutateur 100 est en un matériau dit « chalcogénure », c'est-à-dire un matériau ou un alliage comprenant au moins un élément chalcogène, par exemple un matériau de la famille du tellurure de germanium, du tellurure d'antimoine ou du germanium-antimoine-tellure, plus communément désigné par l'acronyme « GST ». À titre de variante, chaque région 109 est en dioxyde de vanadium.

De manière générale, les matériaux à changement de phase sont des matériaux capables d'alterner, sous l'effet d'une variation de température, entre une phase cristalline et une phase amorphe, la phase amorphe présentant une résistance électrique supérieure à celle de la phase cristalline. Dans le cas du commutateur 100, on tire profit de ce phénomène pour obtenir un état bloqué, empêchant la circulation d'un courant entre les électrodes 105, lorsqu'une partie au moins du matériau des régions 109 est dans la phase amorphe, et un état passant, permettant la circulation du courant entre les électrodes 105, lorsque le matériau des régions 109 est dans la phase cristalline.

Dans l'exemple représenté, la face de chaque région 109 opposée au substrat 101 (la face supérieure de chaque région 109, dans l'orientation de la figure 1B) est revêtue d'une couche électriquement isolante 111. À titre d'exemple, les couches isolantes 111 sont en un matériau diélectrique et thermiquement conducteur, par exemple le nitrure de silicium ou le nitrure d'aluminium. Les couches isolantes 111 n'ont pas été représentées en figure 1A afin de ne pas surcharger le dessin.

Dans l'exemple illustré, le commutateur 100 comporte en outre quatre éléments chauffants 113 situés respectivement sur et en contact avec les faces supérieures des couches 111, à l'aplomb des quatre régions 109 en matériau à changement de phase. Chaque élément chauffant 113 est électriquement isolé de la région 109 sous-jacente par la couche 111 correspondante. Dans l'exemple représenté, chaque élément chauffant 113 présente la forme d'une bande rectangulaire s'étendant le long d'une direction sensiblement orthogonale à la direction de conduction du commutateur 100. Dans l'exemple illustré, les deux extrémités de chaque élément chauffant 113 sont respectivement connectées à deux électrodes de commande 115. Les électrodes de commande 115 de chaque élément chauffant 113 sont par exemple électriquement isolées des électrodes de commande 115 des autres éléments chauffants 113. À titre d'exemple, chaque élément chauffant 113 du commutateur 100 est relié ou connecté, par ses électrodes 115, à un circuit de commande distinct de circuits de commande des autres éléments chauffants 113. Afin de ne pas surcharger le dessin, les circuits de commande des éléments chauffants 113 n'ont pas été représentés en figures 1A et 1B.

Chaque élément chauffant 113 présente par exemple une épaisseur de l'ordre de 100 nm et une largeur comprise entre quelques centaines de nanomètres et quelques micromètres, par exemple comprise entre 500 nm et 3,5 µm, la largeur de chaque élément chauffant 113 correspondant à la dimension latérale dudit élément chauffant 113 mesurée le long de la direction de conduction du commutateur 100. À titre d'exemple, chaque élément chauffant 113 est en un métal, par exemple le tungstène, ou en un alliage métallique, par exemple le nitrure de titane.

Bien que cela n'ait pas été illustré sur les figures, la structure du commutateur 100 peut être revêtue, du côté de la face supérieure du substrat 101, d'une couche thermiquement isolante destinée à confiner la chaleur produite par les éléments chauffants 113.

Lors des commutations du commutateur 100 entre les états passant et bloqué, les électrodes de commande 115 des éléments chauffants 113 du commutateur 100 sont par exemple simultanément soumises à une tension de commande provoquant une circulation de courant à travers les éléments chauffants 113. Ce courant entraîne, par effet Joule puis par rayonnement et/ou conduction à l'intérieur de la structure du commutateur 100, notamment à travers les couches 111, une élévation de température des régions 109 sous-jacentes depuis leurs faces supérieures, situées en regard des éléments chauffants 113 respectifs.

Plus précisément, pour faire basculer le commutateur 100 de l'état bloqué à l'état passant, les régions 109 en matériau à changement de phase sont chauffées, au moyen des éléments chauffants 113, par exemple à une température T1 et pendant une durée d1. La température T1 et la durée d1 sont choisies de sorte à provoquer un changement de phase du matériau des régions 109 depuis la phase amorphe vers la phase cristalline. La température T1 est par exemple supérieure à une température de cristallisation et inférieure à une température de fusion du matériau des régions 109. À titre d'exemple, la température T1 est comprise entre 150 et 350 °C et la durée d1 est inférieure à 1 µs. Dans le cas où les régions 109 sont en tellurure de germanium, la température T1 est par exemple égale à environ 300 °C et la durée d1 est par exemple comprise entre 100 ns et 1 µs.

À l'inverse, pour faire basculer le commutateur 100 de l'état passant à l'état bloqué, les régions 109 en matériau à changement de phase sont chauffées, au moyen des éléments chauffants 113, par exemple à une température T2 supérieure à la température T1, et pendant une durée d2 inférieure à la durée d1. La température T2 et la durée d2 sont choisies de sorte à provoquer un changement de phase du matériau des régions 109 depuis la phase cristalline vers la phase amorphe. La température T2 est par exemple supérieure à la température de fusion du matériau à changement de phase. À titre d'exemple, la température T2 est comprise entre 600 et 1 000 °C et la durée d2 est inférieure à 500 ns. Dans le cas où les régions 109 sont en tellurure de germanium, la température T2 est par exemple égale à environ 700 °C et la durée d2 est par exemple égale à environ 100 ns.

Le commutateur 100 est dit « à chauffage indirect », l'élévation de température du matériau à changement de phase s'obtenant par circulation d'un courant à travers un élément chauffant électriquement isolé du matériau à changement de phase, par opposition aux commutateurs de type « à chauffage direct » qui sont dépourvus d'élément chauffant et dans lesquels l'élévation de température résulte d'une circulation de courant directement à travers le matériau à changement de phase. Dans le cas d'un commutateur à chauffage direct, les électrodes de commande sont par exemple connectées à deux côtés opposés de la région en matériau à changement de phase, par exemple le long d'une direction orthogonale au chemin de conduction du commutateur. Un inconvénient des commutateurs à chauffage direct tient au fait que, lorsque le commutateur est passant, un chemin de conduction électrique est créé à travers le matériau à changement de phase entre les électrodes de commande et les électrodes de conduction du commutateur. Cela entraîne des courants de fuite qui perturbent le signal transmis entre les électrodes de conduction.

Le fait de prévoir plusieurs régions 109 en matériau à changement de phase permet avantageusement de réduire la quantité d'énergie électrique et la durée nécessaires à chaque commutation tout en permettant, à l'état bloqué, d'atteindre une tenue en tension élevée, par exemple supérieure ou égale à 4 V, entre les électrodes 105 de conduction du commutateur 100. Le commutateur 100 présente ainsi, par rapport à un commutateur analogue comprenant une unique région en matériau à changement de phase d'un volume sensiblement identique à la somme des volumes des régions 109 en matériau à changement de phase du commutateur 100, une vitesse de commutation plus élevée, une consommation énergétique moindre et une fiabilité supérieure.

La figure 2 est une vue de dessus, schématique et partielle, d'un commutateur selon l'invention 200 à base d'un matériau à changement de phase selon un mode de réalisation. Le commutateur 200 présente par exemple, vu en coupe selon le plan AA de la figure 2, une structure identique ou analogue à celle illustrée en figure 1B. Les couches isolantes 111 n'ont pas été représentées en figure 2 afin de ne pas surcharger le dessin.

Le commutateur 200 de la figure 2 comprend des éléments communs avec le commutateur 100 de la figure 1. Ces éléments communs ne seront pas détaillés à nouveau ci-après.

Le commutateur 200 de la figure 2 diffère du commutateur 100 de la figure 1 en ce que les régions 109 en matériau à changement de phase du commutateur 200 présentent, en vue de dessus, des aires différentes. Dans l'exemple selon l'invention illustré, les régions 109 en matériau à changement de phase présentent, le long de la direction de conduction du commutateur 200, depuis l'une des électrodes 105 de conduction vers l'autre électrode 105 de conduction (depuis l'électrode 105 de l'extrémité gauche vers l'électrode 105 de l'extrémité droite, dans l'orientation de la figure 2), des aires strictement croissantes. Dans l'exemple selon l'invention représenté, les régions 109 en matériau à changement de phase présentent la même longueur, aux dispersions de fabrication près, et des largeurs différentes, par exemple strictement croissantes entre les deux électrodes 105 de conduction du commutateur 200. À titre d'exemple, l'électrode 105 de conduction en contact avec la région 109 présentant l'aire la plus grande est adaptée à être portée à un potentiel haut, par exemple supérieur ou égal à 4 V, l'autre électrode 105 de conduction, en contact avec la région 109 présentant l'aire la plus petite, dans cet exemple, étant destinée à être portée à un potentiel de référence, par exemple la masse radiofréquence. Par ailleurs, l'écart d'aires, ou de largeurs, entre deux régions 109 en matériau à changement de phase successives est d'autant plus important que les régions 109 sont proches de l'électrode 105 de conduction en contact avec la région 109 présentant l'aire la plus grande (proches de l'électrode 105 de l'extrémité droite, dans l'orientation de la figure 2).

La largeur, ou l'aire, de chaque région 109 est par exemple déterminée de sorte que, lorsque le commutateur 200 est à l'état bloqué et qu'une tension, résultant de l'application du signal radiofréquence, est appliquée entre ses électrodes 105 de conduction, les tensions résultantes individuellement appliquées à chaque région 109, c'est-à-dire, pour chaque région 109, la tension appliquée entre les deux électrodes 105 qu'elle relie, soient sensiblement identiques, ou équilibrées. Cela permet avantageusement d'améliorer la tenue en tension du commutateur 200.

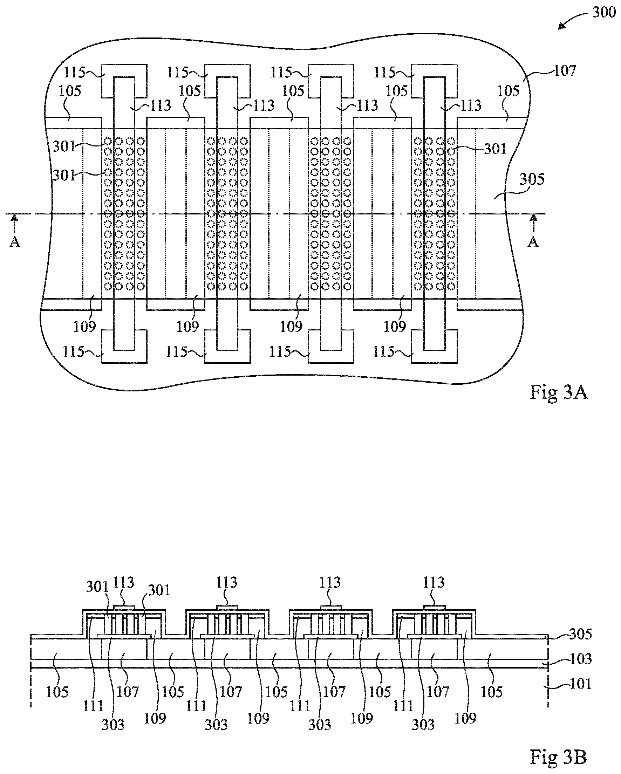

La figure 3A et la figure 3B sont des vues, respectivement de dessus et en coupe selon le plan AA de la figure 3A, schématiques et partielles, d'un exemple d'un commutateur 300 à base d'un matériau à changement de phase.

Dans l'exemple représenté, le commutateur 300 comprend des piliers 301 s'étendant dans chaque région 109 en matériau à changement de phase. Plus précisément, dans l'exemple illustré, les piliers 301 s'étendent verticalement à travers toute l'épaisseur des régions 109.

Les piliers 301 sont par exemple en un matériau présentant une conductivité thermique supérieure à celle du matériau à changement de phase des régions 109. À titre d'exemple, les piliers 301 sont en un matériau électriquement isolant et thermiquement conducteur, par exemple le nitrure de silicium, le nitrure d'aluminium, etc. En variante, les piliers 301 peuvent être en un matériau électriquement et thermiquement conducteur, par exemple un métal. Toutefois, pour une mise en œuvre du commutateur 300 dans des applications de communication radiofréquence, l'utilisation de piliers 301 en un matériau électriquement isolant est privilégiée de sorte à limiter, ou éviter, l'apparition de phénomènes capacitifs parasites.

Dans l'exemple représenté, les piliers 301 présentent chacun, en vue de dessus, une section sensiblement circulaire. Cet exemple n'est toutefois pas limitatif, les piliers 301 pouvant présenter une forme quelconque, par exemple une section de forme rectangulaire ou carrée. À titre d'exemple, chaque pilier 301 présente une dimension latérale maximale (par exemple un diamètre, dans l'exemple représenté où les piliers ont une section sensiblement circulaire) égale à environ 300 nm. En outre, chaque pilier 301 est par exemple séparé des piliers 301 voisins par une distance de l'ordre de 300 nm. Les piliers 301 sont par exemple répartis, à l'intérieur de chaque région 109 en matériau à changement de phase, selon un motif périodique. Bien que l'on ait illustré un exemple dans lequel chaque région 109 du commutateur 300 comporte quelques dizaines de piliers 301, chaque région 109 du commutateur 300 peut comporter un nombre quelconque, supérieur ou égal à un, de piliers 301.

La présence des piliers 301 procure l'avantage que la chaleur produite par chaque élément chauffant 113 est propagée plus efficacement dans la région 109 en matériau à changement de phase sous-jacente. En particulier, par rapport aux commutateurs 100 et 200 dont les régions 109 sont chauffées principalement depuis leurs faces supérieures respectives, la chaleur provenant des éléments chauffants 113 du commutateur 300 se diffuse en outre au cœur du matériau à changement de phase des régions 109 sous-jacentes. Le commutateur 300 présente ainsi une efficacité thermique supérieure à celle des commutateurs 100 et 200.

Dans le cas du commutateur 300, pour une même tension de commande appliquée entre les électrodes de commande 115 des éléments chauffants 113, ceux-ci subissent, par rapport aux éléments chauffants 113 du commutateur 100, une élévation de température moindre. En outre, pour la même tension de commande, les régions 109 du commutateur 300 subissent, par rapport aux régions 109 du commutateur 100, une élévation de température supérieure. La différence entre les températures atteintes respectivement par l'élément chauffant 113 et par la région 109 lors des étapes de commutation est moindre dans le cas du commutateur 300 que dans le cas du commutateur 100.

À épaisseurs de régions 109 comparables, le commutateur 300 permet d'accéder à des durées de commutation inférieures, ou à des vitesses de commutation supérieures, à celles du commutateur 100. Il est avantageusement possible de tirer profit de l'efficacité thermique accrue du commutateur 300 pour augmenter l'épaisseur des régions 109 par rapport au commutateur 100, afin d'améliorer le facteur de mérite du commutateur 300, sans dégrader les durées de commutation par rapport au commutateur 100. On peut en outre avantageusement éloigner les éléments chauffants 113 par rapport aux régions 109 sous-jacentes. Cela provoque alors une diminution de capacité à l'état bloqué, donc une amélioration du facteur de mérite, du commutateur 300 par rapport au commutateur 100.

Dans l'exemple représenté, les piliers 301 traversent les couches 111 sur toute leur épaisseur. Plus précisément, dans cet exemple, chaque pilier 301 s'étend verticalement depuis la face supérieure de l'une des couches isolantes 111 jusqu'à la face inférieure de la région 109 sous-jacente.

Dans l'exemple illustré, le commutateur 300 comprend en outre, de façon optionnelle, des régions électriquement isolantes 303 disjointes revêtant chacune une partie de la couche électriquement isolante 107 s'étendant entre deux électrodes 105 adjacentes, la région 303 se prolongeant sur et en contact avec une partie de la face supérieure de chacune desdites électrodes 105. Chaque région 303 présente par exemple une épaisseur de l'ordre de 20 nm. À titre d'exemple, les régions électriquement isolantes 303 sont en un matériau diélectrique, par exemple le nitrure de silicium.

Dans l'exemple représenté, le commutateur 300 comporte en outre une couche électriquement isolante 305 interposée entre les couches 111 et les éléments chauffants 113 sus-jacents. Dans l'exemple illustré, la couche 305 revêt la face supérieure des piliers 301, la face supérieure et les flancs des couches 111, les flancs des régions 109 et les parties exposées des faces supérieures des électrodes 105. À titre d'exemple, la couche 305 est en un matériau électriquement isolant et thermiquement conducteur, par exemple le même matériau que celui des piliers 301, par exemple le nitrure de silicium ou le nitrure d'aluminium.

Le commutateur 300 présente une structure dans laquelle les éléments chauffants 113 sont plus éloignés du substrat 101 que les couches 109 en matériau à changement de phase. Cela entraîne la présence d'une capacité thermique faible, les éléments chauffants 113 pouvant être situés à proximité de l'air ambiant. Il en résulte avantageusement des échanges thermiques rapides, donc des durées de commutation réduites.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, la personne du métier est capable, à partir des indications de la présente description, de combiner le mode de réalisation du commutateur 300 avec ceux des commutateurs 100 et 200, en prévoyant notamment des piliers analogues ou identiques aux piliers 301 du commutateur 300 dans chaque région 109 en matériau à changement de phase des commutateurs 100 et 200.

Par ailleurs, bien que des exemples de commutateurs 100, 200 et 300 comprenant chacun cinq électrodes 105 et quatre régions 109 en matériau à changement de phase aient été représentés et décrits, la personne du métier est capable d'adapter les modes de réalisation de la présente description à des commutateurs à base de matériau à changement de phase comprenant un nombre N entier supérieur ou égal à trois d'électrodes 105 et un nombre N-1 de régions 109 en matériau à changement de phase, la région 109 de rang k (1 ≤ k ≤ N-1) reliant l'électrode 105 de rang k à l'électrode 105 de rang k+1.

Par ailleurs, bien que des exemples de commutateurs 100, 200 et 300 présentant des électrodes 105 coplanaires aient été représentés et décrits, ces exemples ne sont pas limitatifs et la personne du métier est capable d'adapter les modes de réalisation décrits à un cas où les électrodes 105 du commutateur ne sont pas coplanaires.

Enfin, la mise en œuvre pratique des modes de réalisation et variantes décrits est à la portée de la personne du métier à partir des indications fonctionnelles données ci-dessus. En particulier, les modes de réalisation décrits ne se limitent pas aux exemples particuliers de matériaux et de dimensions mentionnés dans la présente description, l'invention étant définie par les revendications.

## Revendications

1. Commutateur (100 ; 200 ; 300) à base d'un matériau à changement de phase comprenant :
- une première électrode (105), une ou plusieurs deuxièmes électrodes (105) et une troisième électrode (105), parmi lesquelles :
les première et troisième électrodes (105) sont des électrodes de conduction situées respectivement à des extrémités du commutateur et destinées à être connectées à un circuit de communication radiofréquence, et
la ou les deuxièmes électrodes (105) sont des électrodes intermédiaires, interposées latéralement entre les première et deuxième électrodes (105) et destinées à n'être reliées ou connectées à aucun autre élément conducteur ;
- une première région (109) en ledit matériau à changement de phase reliant la première électrode et la ou l'une des deuxièmes électrodes (105) ; et
- une deuxième région (109) en ledit matériau à changement de phase reliant la troisième électrode et la ou l'une des deuxièmes électrodes (105),
**caractérisé en ce que** les première et deuxième régions (109) en ledit matériau à changement de phase présentent, en vue de dessus, des aires différentes.

2. Commutateur selon la revendication 1, dans lequel les première et deuxième régions (109) en ledit matériau à changement de phase présentent, le long de la direction de conduction du commutateur (100 ; 200 ; 300), une même dimension latérale.

3. Commutateur selon la revendication 1 ou 2, dans lequel les première et deuxième régions (109) en ledit matériau à changement de phase présentent, le long d'une direction orthogonale à la direction de conduction du commutateur (100 ; 200 ; 300), des dimensions latérales différentes.

4. Commutateur selon l'une quelconque des revendications 1 à 3, dans lequel chacune des première et deuxième régions (109) en ledit matériau à changement de phase comprend un ou plusieurs piliers (301) s'étendant chacun dans ladite région, le ou les piliers (301) étant en un matériau présentant une conductivité thermique supérieure à celle dudit matériau à changement de phase.

5. Commutateur selon la revendication 4, dans lequel le matériau du ou des piliers (301) est électriquement isolant.

6. Commutateur selon la revendication 4 ou 5, dans lequel le matériau du ou des piliers (301) est choisi parmi le nitrure d'aluminium et le nitrure de silicium.

7. Commutateur selon l'une quelconque des revendications 4 à 6, dans lequel chaque pilier (301) présente une dimension latérale maximale égale à environ 300 nm.

8. Commutateur selon l'une quelconque des revendications 4 à 7, dans lequel chaque pilier (301) est séparé des piliers voisins par une distance de l'ordre de 300 nm

9. Commutateur selon l'une quelconque des revendications 1 à 8, dans lequel ledit matériau à changement de phase est un matériau chalcogénure.

10. Commutateur selon l'une quelconque des revendications 1 à 9, comprenant en outre des premier et deuxième éléments chauffants (113) situés respectivement en vis-à-vis des première et deuxième régions (109) en ledit matériau à changement de phase, chaque élément chauffant étant électriquement isolé de ladite région située en vis-à-vis.

## Patentansprüche

1. Schalter (100; 200; 300), der auf einem Phasenänderungs-Material basiert, der Folgendes aufweist:
- eine erste Elektrode (105), eine oder mehrere zweite Elektroden (105) und eine dritte Elektrode (105), unter denen:
die erste und die dritte Elektrode (105) Leitungs-Elektroden sind, die sich jeweils an Enden des Schalters befinden und dazu bestimmt sind, mit einer Hochfrequenz-Kommunikationsschaltung verbunden zu werden, und
die zweite(n) Elektrode(n) (105) Zwischen-Elektroden sind, die seitlich zwischen der ersten und der zweiten Elektrode (105) angeordnet sind und dazu bestimmt sind, nicht mit einem anderen leitenden Element gekoppelt oder verbunden zu werden;
- einen ersten Bereich (109) aus dem Phasenänderungs-Material, der die erste Elektrode und die oder eine der zweiten Elektrode(n) (105) koppelt; und
- einen zweiten Bereich (109) aus dem Phasenänderungs-Material, der die dritte Elektrode und die oder eine der zweiten Elektrode(n) (105) koppelt, **dadurch gekennzeichnet, dass** der erste und der zweite Bereich (109) aus dem Phasenänderungs-Material in Draufsicht unterschiedliche Flächen haben.

2. Schalter nach Anspruch 1, wobei der erste und der zweite Bereich (109) aus dem Phasenänderungs-Material entlang der Leitungs-Richtung des Schalters (100; 200; 300) eine gleiche laterale Dimension haben.

3. Schalter nach Anspruch 1 oder 2, wobei der erste und der zweite Bereich (109) aus Phasenänderungs-Material entlang einer Richtung orthogonal zur Leitungs-Richtung des Schalters (100; 200; 300) unterschiedliche laterale Dimensionen haben.

4. Schalter nach einem der Ansprüche 1 bis 3, wobei jeder des ersten und des zweiten Bereichs (109) aus dem Phasenänderungs-Material einen oder eine Vielzahl von Pfeilern (301) aufweist, die sich jeweils in dem Bereich erstrecken, wobei der/die Pfeiler (301) aus einem Material hergestellt sind, das eine Wärmeleitfähigkeit aufweist, die größer ist als die des Phasenänderungs-Materials.

5. Schalter nach Anspruch 4, wobei das Material des/der Pfeiler(s) (301) elektrisch isolierend ist.

6. Schalter nach Anspruch 4 oder 5, wobei das Material des/der Pfeiler(s) (301) aus Aluminiumnitrid und Siliziumnitrid ausgewählt ist.

7. Schalter nach einem der Ansprüche 4 bis 6, wobei jeder Pfeiler (301) eine maximale laterale Dimension gleich ungefähr 300 nm hat.

8. Schalter nach einem der Ansprüche 4 bis 7, wobei jeder Pfeiler (301) von den benachbarten Pfeilern durch einen Abstand in der Größenordnung von 300 nm getrennt ist.

9. Schalter nach einem der Ansprüche 1 bis 8, wobei das Phasenänderungs-Material ein Chalkogenid-Material ist.

10. Schalter nach einem der Ansprüche 1 bis 9, der ferner erste und zweite Heiz-Elemente (113) aufweist, die sich jeweils vor dem ersten und dem zweiten Bereich (109) befinden, die aus dem Phasenänderungs-Material hergestellt sind, wobei jedes Heiz-Element von dem Bereich, der sich davor befindet, elektrisch isoliert ist.

## Claims

1. Switch (100; 200; 300) based on a phase-change material comprising:
- a first electrode (105), one or more second electrodes (105), and a third electrode (105), among which:
the first and third electrodes (105) are conduction electrodes located respectively at ends of the switch and intended to be connected to a radio frequency communication circuit, and
the second electrode(s) (105) are intermediate electrodes, interposed laterally between the first and second electrodes (105) and intended not to be coupled or connected to any other conductive element;
- a first region (109) of said phase-change material coupling the first electrode and the or one of the second electrode(s) (105); and
- a second region (109) of said phase-change material coupling the third electrode and the or one of the second electrode(s) (105),
**characterized in that** the first and second regions (109) of said phase-change material have, in top view, different areas.

2. Switch according to claim 1, wherein the first and second regions (109) of said phase-change material have, along the conduction direction of the switch (100; 200; 300), a same lateral dimension.

3. Switch according to claim 1 or 2, wherein the first and second regions (109) of phase-change material have, along a direction orthogonal to the conduction direction of the switch (100; 200; 300), different lateral dimensions.

4. Switch according to any one of claims 1 to 3, wherein each of the first and second regions (109) of said phase-change material comprises one or a plurality of pillars (301) each extending in said region, the pillar(s) (301) being made of a material having a thermal conductivity greater than that of said phase-change material.

5. Switch according to claim 4, wherein the material of the pillar(s) (301) is electrically insulating.

6. Switch according to claim 4 or 5, wherein the material of the pillar(s) (301) is selected from among aluminum nitride and silicon nitride.

7. Switch according to any one of claims 4 to 6, wherein each pillar (301) has a maximum lateral dimension equal to approximately 300 nm.

8. Switch according to any one of claims 4 to 7, wherein each pillar (301) is separated from the neighboring pillars by a distance in the order of 300 nm.

9. Switch according to any one of claims 1 to 8, wherein said phase-change material is a chalcogenide material.

10. Switch according to any one of claims 1 to 9, further comprising first and second heating elements (113) respectively located in front of the first and second regions (109) made of said phase-change material, each heating element being electrically insulated from said region located in front thereof.
